# EUROPEAN PATENT APPLICATION

(11) **EP 0 854 201 A1**
(43) Date of publication of application: **22.07.1998**
(21) Application number: 98300251.0
(22) Date of filing: 14.01.1998
(51) Int. Cl.: C23C 14/04

(54) **Three-dimensional masking method for control of optical coating thickness**

(30) Priority: 20.01.1997 GB 9701114; 23.10.1997 GB 9722295
(71) Applicant: Coherent Optics Europe Limited, Whetstone, Leicester LE8 6NU (GB)
(72) Inventor: Boucher, Neil, Whetstone, Leicester LE8 6NU (GB)
(74) Representative: Tillbrook, Christopher John

(57) **Abstract**

A method of vacuum depositing a layer or layers on a substrate includes controlling thickness distribution of the layer or layers over the substrate by a three-dimensional mask located between the substrate and a vapour source. A plurality of conduits extends through the mask from one side to the other for allowing passage of gaseous coating material from a source to the substrate. The throughput of the conduits for gaseous coating and thus the amount of gaseous material transmitted by the conduits is inversely related to the ratio of length to diameter of the conduits. The conduit dimensions are graded progressively over the mask to provide corresponding gradation of a deposited layer.

## Description

### Technical Field Of The Invention

The present invention relates in general to methods of controlling layer thickness in the vacuum deposition of optical coatings including one or more coating layers. It relates in particular to a method wherein coating layer thickness on a substrate is controlled by a three-dimensional mask located between the substrate and a vapour source, the mask having a vapour acceptance angle which is spatially varied over the mask area.

### Discussion Of Background Art

Prior art methods for control of spatial distribution of layer thickness in vacuum deposited coatings have been devised primarily with one of two goals. One of these goals is the formation of a layer or layers of uniform thickness on a substrate. The other is the forming a layer or layers the thickness of which varies in a predetermined manner over the surface of a substrate.

One of the earliest, and still-used, methods of achieving layer thickness uniformity involved rotating a flat, or slightly dome-shaped, substrate holder, to which one or more substrates could be attached, about a central axis offset from a source of vapour which condenses on the substrates to form a layer. Using this method it is possible to achieve an approximately uniform layer thickness over the entire area of the substrate holder, the degree of uniformity being determined primarily by the ratio of the offset of the rotation axis to the height of the substrate holder above the vapour source. The smaller the substrate holder relative to the height above the source, the greater the uniformity achievable. This method has been embellished by additionally providing rotation of the substrate holder about an axis offset from the center of the substrate holder, such that the substrate holder is doubly rotated in a "planetary" fashion relative to the source. Any sub-area of the substrate holder receives vapour from the source at a range of incidence angles during the course of deposition. One important advantage of this planetary method is that non-uniformity of vapour output from the evaporation source is compensated for. The planetary method may be adapted for the application of approximately uniform layers to a substrate which is flat, or to a substrate such as a lens element or a dome, which has a finite surface curvature.

The above methods are sometimes further embellished, either for providing more exact uniformity or for coating non-flat surfaces, by locating a solid, leaf-type mask of a suitable profile between the substrate holder and the vapour source. This mask is typically placed relatively close to the substrate holder, partially shielding the substrate holder from vapour from the source. The mask is arranged such that rotation of the substrate holder about its central axis rotates the substrate holder relative to the mask. Sometimes, too, the leaf mask is counter-rotated with respect to the primary rotation of the substrate holder.

There are several applications in which it is required to deposit one or more layers having thicknesses which vary across the surface of the substrate in a predetermined manner. One such application is a multi-layer optical interference device in which the primary operating wavelength varies spatially over the coated substrate. An example of such a device is a narrow-band filter deposited on a disc shaped substrate, with the peak transmission wavelength varying versus angular position on the disc. This type of device is generally referred to as a circular variable filter (CVF) and may be used in conjunction with a light source, slit, and detector to form a spectrophotometer. Another device, a colour cross-fading system described in US Patent No. 5,426,576, consists of a pair of circular variable long- and shortwave-pass filters. These devices would typically require a layer thickness ratio, between extremes, of about 2:1 to cover the visible spectrum.

One method for making these and similar types of device is disclosed in US Patent No. 3,442,572. The method involves depositing coating material on a disc-shaped substrate by the use of first and second masks. The first and second masks and the substrate form three elements, and at least two of the elements are rotated with respect to each other, and to the third element, to cause the material to be deposited on the substrate so that the optical thickness of coating layers varies with azimuthal angle over a segment of the substrate. While elegant in concept, this method requires two masks and the necessary relative rotation of those masks for each substrate to be coated. This makes mass production of such devices by this method a daunting prospect.

Another method of forming layers having a predetermined thickness variation is described, by J. R. Kurdock and R. R. Austin in *"Physics of Thin Films Vol. 10",* pp 261-308, Academic Press (1978). Here, a mask having a spatially varying transmission for coating vapour is placed between a source and a substrate. The mask is prepared by plating a half-tone pattern of metal dots on a wire mesh or wirecloth screen using a complex, computer controlled lithographic process. The mask is essentially "two-dimensional" inasmuch as it is formed from a very thin material and spatially varying layer thickness is achieved by spatially varying the size of apertures in the mask through which coating vapour can pass, these areas having a width significantly greater than the thickness of the material.

This method was devised primarily for aspherizing or correcting a surface of an optical element by addition of material to the surface. The description, however, also discloses that layers of spatially variable thickness produced by the method are useful for other applications. Applications include forming a transparent conductive coating having a spatially varying thickness, in order to facilitate the uniform heating of an irregularly shaped window; providing a filter or antireflection coating for a window on which useful light is incident at various different angles according to the position upon the window that the light is incident; and for providing a bandpass filter with a position dependent passband wavelength.

The method has several drawbacks. One disadvantage is that, as described, the mask making process takes several hours. Another is that the mesh of the mask is not rigid and must be stretched in a rigid frame to maintain the flatness necessary to ensure uniform separation of the mask from the substrate being coated. Further, a preferred wirecloth is formed from 0.0834 mm (0.0037 inch) diameter wires in a 70 mesh weave, which suggests that such a mask would have a maximum vapour transmission of between about fifty and sixty percent and may become blocked by coating material during deposition of a filter having multiple thick layers.

A similar approach is later described in US Patent No. 5,389,397. In this instance, a large number of small holes are chemically etched in a thin sheet of metal. In common with the other methods described above, this is a purely two dimensional technique.

### Summary Of The Invention

According to one aspect of the present invention, a method for vacuum depositing a layer of a material on a substrate comprises the steps of:
causing the material in a gaseous form
to impinge and condense upon the substrate;
while partially shielding the substrate from the gaseous material,
by locating a mask
between the substrate and a gaseous material source;
the mask extending at least partially over the substrate,
and including a plurality of conduits,
extending from one side thereof to the other,
through which the gaseous form of the material can pass selectively
to reach the substrate;
the nature and effect of the conduits being varied
over the mask area
in a predetermined manner,
for controlling depth of the layer of material
deposited on the substrate.

In a particular methodology,
the substrate and mask are rotated
with respect to the gaseous material source,
such that gaseous material from the source
is incident on any sub-area of the mask,
at a range of incidence angles,
depending on the location of the sub-area of the mask
and the rotary path of the sub-area
with respect to the gaseous material source;
each conduit having a characteristic 'angular acceptance' for the gaseous material,
the angular acceptance of the conduits
being inversely related to the ratio of length to diameter of the conduits,
the amount of gaseous material transmitted by the conduits
being directly related to the acceptance angle.

According to another aspect of the present invention,
apparatus for deposition upon a substrate comprises:
a vacuum chamber,
to receive a substrate to be coated,
vaporising means for vaporising a material to be deposited,
and directing the material in a gaseous form
to impinge and condense upon the substrate;
a mask between the substrate and the vaporising means,
partially shielding the substrate from the gaseous material;
the mask extending at least partially over the substrate,
and including a plurality of conduits,
extending from one side thereof to the other,
through which the gaseous material can pass
from the source to reach the substrate;
the respective lengths of the conduits differing over the mask area
in a predetermined manner,
to achieve a desired deposition layer depth
and spatial distribution upon the substrate.

For the deposition method, the invention further provides,
a dedicated mask with a plurality of conduits,
juxtaposed alongside one another in an array
corresponding to a desired spatial variation in coating deposition depth.

The mask configuration may selectively combine various conduit depths and cross-sectional shapes and sizes to achieve a desired coating depth distribution.

The conduits of the mask may be aligned parallel to each other and transverse to the area of the mask. Ends of the conduits closest the substrate are desirably equidistant from the surface of the substrate being coated.

The mask is made of a multi-cellular material with a cell array extending from one side of the mask to the other to provide conduits.

A particular mask configuration uses a flat, parallel-sided sheet or slab of a metal "honeycomb" material having elongated hexagonal honeycomb "cells" extending through the slab transverse to surfaces (sides) thereof, from one side to the other. The hexagonal cells have a vertex-to-vertex dimension of about four millimeters (4 mm) and provide the conduits through which gaseous coating material passes.

One surface or side of the slab may be shaped to a first surface contour corresponding to a curvature of a substrate or substrate holder, or left flat if the substrate or holder is flat. The opposite surface is shaped to a differentiated surface contour which, together with the first surface contour, will provide the spatial variation of conduit length required to provide the desired spatial variation of coating thickness.

The conduits are preferably arranged such that a conduit in a sub-area of the mask through which maximum coating material transmittance is required passes vapour from the largest possible range of angles of incidence. This minimizes the amount of coating material which is prevented from reaching the substrate, thereby optimizing efficiency of the coating process.

The present invention further provides, a substrate with a coating of predetermined, spatially varying or even depth over its surface, produced by the deposition method.

Such a substrate may be an optical filter is produced with an optical coating of predetermined spatially varying thickness.

In addition to providing a layer or multiple layer coatings of spatially varying thickness, the method of the present invention may be used for providing uniform layers on a flat substrate having an area greater than the area that could be uniformly coated employing only single or double rotation methods in the same apparatus. The method may also be used for providing a uniform layer or layers on a non-flat surface.

Coating masks suitable for use with the present invention may be quickly and inexpensively produced using computer controlled machining techniques, or by spark erosion. Such bespoke coating masks, combined with planetary rotation of multiple substrate holders, provide that even the most complex multi-layer filter devices consisting of layers with spatial thickness variation may be made plurally, in a single coating cycle, and at a cost significantly less than is possible using prior art methods. An additional advantage over some prior art methods is that the spatial variation of coating thickness does not have to be symmetrical in any way.

### Brief Description Of The Drawings

The accompanying drawings, which are incorporated in and constitute a part of the specification, schematically illustrate a preferred embodiment of the present invention, and together with the general description given above and the detailed description of the preferred embodiment given below, serve to explain the principles of the invention.

FIG. 1 is a partial perspective view, schematically illustrating a prior art thermal-evaporation coating layer deposition apparatus including an offset single-rotation substrate holder and an evaporation source.

FIG. 2 is a partial perspective view, schematically illustrating a prior art thermal-evaporation coating layer deposition apparatus including a plurality of double-rotation or planetary substrate holders and two evaporation sources.

FIG. 3 is a general cross-section view schematically illustrating operating principles of a variable transmission mask in accordance with the present invention.

FIG. 4 is a general cross-section view schematically illustrating a double-rotation or planetary drive arrangement including a substrate holder, a substrate, and a variable-transmission mask in accordance with the present invention.

FIG. 5 is a plan view schematically illustrating an annular-segment-shaped block of a honeycomb material for forming a variable-transmission mask in accordance with the present invention, suitable for making a circular variable filter.

FIG. 6 is an elevation view of the honeycomb material block of FIG. 5 seen generally in the direction 6-6 of FIG. 5.

FIG. 7 is a perspective view of a mask formed from the honeycomb material block of FIG. 5 having a flat rear surface and a helicoidal front side.

FIG. 8 is a partial cross section view schematically illustrating location of the mask of FIG. 7 with respect to a substrate to be coated through the mask, the mask and substrate being located in the planetary drive arrangement of FIG. 4.

FIG. 9 is a graph showing the cut-on edge wavelength, as a function of angular position, in a segment of a circular variable dichroic longwave-pass filter which was deposited via a three-dimensional mask in accordance with the present invention.

FIG. 10 is a schematic cross-sectional view showing a dome-shaped substrate and a dome-shaped variable transmission mask in accordance with the present invention for depositing a uniform thickness layer on the convex surface of the dome-shaped substrate.

### Detailed Description Of The Invention

As discussed above, the method comprises causing coating material in a gaseous form to impinge and condense on the substrate, while partially shielding the substrate from the gaseous material by a mask held in a fixed, spaced-apart position relative to the substrate. The mask is located between the substrate and the gaseous material source, and has an area extending at least partially over the substrate. Preferably the substrate and mask are rotated in at least one axis with respect to a source providing the gaseous material.

It should be noted, here, that the term "gaseous form", or simply "gaseous", is used in a general sense and is intended to encompass any form of vapour or mixture of gases, whether dissociated, ionized or neutral, which are condensed on a substrate to form a layer.

In a preferred embodiment, the invention is characterized in that the substrate and mask are rotated with respect to the gaseous material source such that gaseous material from the source is incident on essentially any sub-area of the mask at a range of incidence angles depending on the location of the sub-area of the mask, and the rotary path of the sub-area with respect to the gaseous material source. The mask includes a plurality of conduits through which the gaseous form of the material passes to reach the substrate.

Two rotation arrangements are preferred for achieving the range-of-incidence-angles condition which cooperates with the mask of the present invention to provide variable layer thickness. These arrangements are well-known to practitioners of the art and have been used with other forms of mask discussed above, nevertheless, a review of important features of these rotation schemes is presented below to facilitate understanding how the mask of the present invention functions.

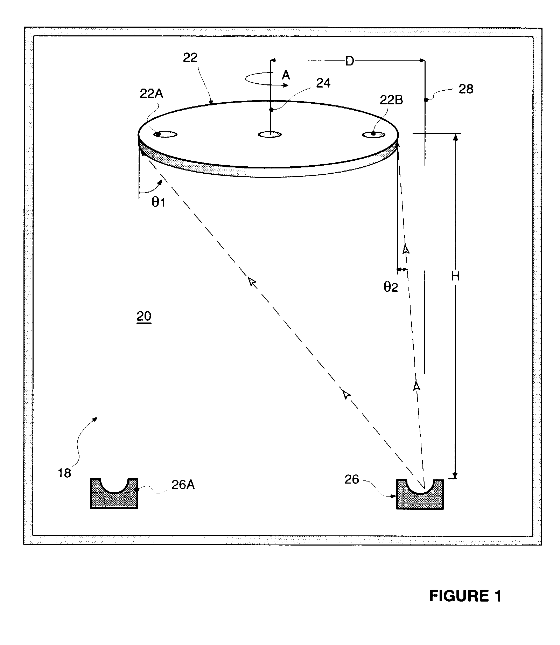

Turning now to the drawings, wherein like components are designated by like reference numerals, FIG. 1 illustrates a first preferred rotation scheme 18. In scheme 18, an evacuable chamber 20 encloses a substrate holder 22 which is arranged to rotate about a central axis 24 as indicated by arrow A. Substrate holder 22 is located at a vertical distance (height) H above at least one source 26 for providing gaseous coating material. At least one additional source 26A may be provided, as illustrated. This source may be used sequentially with source 26 for providing alternating layers of different materials, or used simultaneously with source 26 for co-depositing separate component materials of a single layer. Rotation axis 24 of the substrate holder is offset by a distance D from a vertical axis 28 through source 26. Source 26A is preferably similarly located with respect to substrate holder 22.

Those familiar with the optical coating art will recognize that spatial distribution of film thickness over substrate holder is a function primarily of height H, offset D, the diameter of substrate holder 22, and the angular emission characteristics of gaseous coating material from source 26. Source 26 may be any source, including but not limited to, a resistance heated source, electron beam heated source, or a plasma activated source such as a sputter-gun. In relatively low vacuum depositions, such as might be encountered in reactive deposition, spatial uniformity of the layer may additionally be dependent on pressure in chamber 20.

Gaseous material from source 26 is incident on substrate holder 22 at a maximum angle of incidence θ1 and a minimum angle θ₂. At an instant during rotation of substrate holder 22, gaseous material will be incident on a sub-area 22A of the substrate holder 22 at angles close to the maximum angle, and will be incident on sub-area 22B at angles close to the minimum angle. At a following instant, when substrate holder 22 has rotated 180 degrees, the opposite will be true. As substrate holder 22 rotates at least once, and typically many times, during the deposition of a layer, it can be seen that essentially any sub-area of the substrate holder will receive gaseous coating material at a range of incidence angles between θ₁ and θ₂, depending on its position on the substrate holder. The range of angles received by the sub-area will of course be less, the closer that sub-area is to rotation axis 24 of the substrate holder. The terminology "essentially any", here, is used in recognition that, in theory at least, an infinitesimally small area on axis 24 will receive gaseous material at only one angle of incidence.

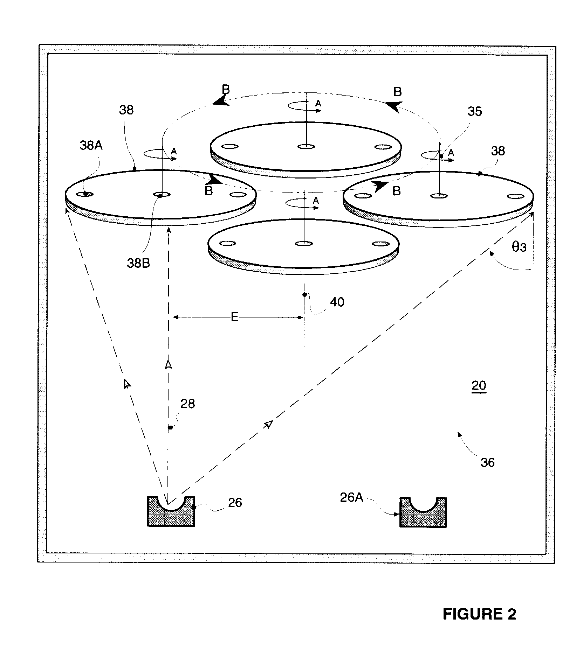

Referring now to FIG. 2, a second rotation arrangement 36 for achieving the range-of-incidence-angles condition important in the method of the present invention is illustrated. Rotation arrangement 36 is usually referred to by practitioners of the optical coating art as a double-rotation or planetary rotation arrangement. Rotation arrangement 36 includes four substrate holders 38, each thereof rotated about a central axis 35 thereof as indicated by arrow A, and additionally rotated about a centrally-therebetween located axis 40 as indicated by arrows B. It should be noted here that four substrate holders are illustrated merely by way of example, as the arrangement is effective with more or less substrate holders, and even with only one substrate holder.

Substrate holders 38 are located above an evaporation source 26, here, offset by a distance E from rotation axis 40. At least one other source 26A may also be provided for reasons discussed above. Any non-centrally located sub-area 38A of a substrate holder 38 describes a spiral path around chamber 20. A centrally located sub-area 38B can not be exactly described as following a spiral path, nevertheless, even an infinitesimally small central sub-area in this rotation scheme receives coating material at a range of incidence angles as it rotates around the chamber. Any sub-area of any substrate holder 38 receives gaseous material from source 26 at a range of incidence angles. The maximum possible incidence angle in arrangement 36 is θ₃. The minimum possible incidence angle is normal (zero) incidence when a substrate is located directly over source-axis 28.

The planetary rotation arrangement of FIG. 2 can provide superior layer thickness uniformity and repeatability over a substrate holder than the single rotation arrangement of FIG. 1. This is due at least in part to the fact that dual rotation of the substrate holders 38 tends to compensate for any asymmetric output characteristic of source 26.

It should be noted here that while single and double-rotation arrangements 18 and 36 have been illustrated with substrate holder rotation axes thereof parallel to source axis 28 of gaseous material source 26, the substrate holders' axes may be inclined either away from or toward the source axis without compromising effectiveness of the present invention. Such inclination of the substrate holder rotation axis is often used in double-rotation arrangement 36, for example, to provide uniform coating thickness over a non-flat lens element.

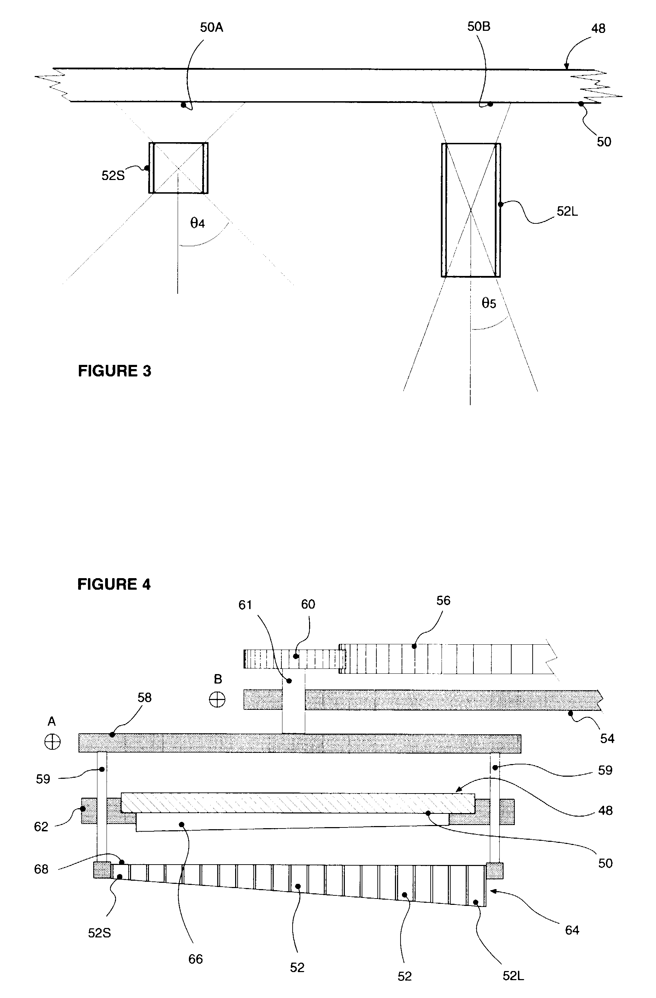

Referring now to FIG. 3 an important principle of the mask of the present invention is illustrated. Here a section 48 of a flat substrate is shown, it being assumed that substrate section 48 is being held in a substrate holder in either arrangement 18 or 36. Suspended below surface 50 of substrate 48 and spaced-apart therefrom (by means not shown) are short and long tubes or conduits 52S and 52L (shown in cross-section) respectively, each tube having the same diameter. Short tube 52S, controls deposition on sub-area 50A of substrate surface 50, and is able to accept gaseous coating material at any incidence angle up to a maximum acceptance angle of ± θ₄. Long tube 52L controls deposition on sub-area 50B of substrate surface 50, and is able to accept gaseous coating material at any incidence angle up to a maximum acceptance angle of ±θ₅ where θ₅ < θ₄. Were substrate 48 arranged such that, in the absence of tubes 52S and 52L, sub-areas 50A and 50B would receive the same amount of gaseous coating material, thus providing the same coating layer thickness in those sub-areas, in the presence of the tubes the ratio of layer thicknesses in sub-areas 50A and 50B would be related directly to the ratio θ₄:θ₅, i.e., inversely related to the length of the tubes 52S and 52L.

A preferred planetary drive arrangement using a mask in accordance with the present invention is illustrated in FIG. 4. Here, a planet support 54 is rotated about an axis (not shown) to provide rotary motion B of FIG. 2. Suspended from support 54 is a planet 58 which is driven by a gear 60 meshing with the stationary main gear 56 and a drive shaft 61 to provide rotary motion A of FIG. 2. Suspended from planet 58 by bolts 59 is a substrate holder 62 in which substrate 48 is located. Also suspended from planet 58 by bolts 52 is a mask 64. Mask 64 is retained, by this mounting method, in a fixed relationship to substrate 48, and extends over the entire surface of the substrate. The mask and substrate are rotated by planet 58 as the planet is rotated.

Mask 64 includes a plurality of contiguous conduits 52 extending therethrough from one side thereof to the other, for permitting the passage of gaseous coating material through the mask. The conduits are of various lengths continually graded from a shortest 52(S) to a longest 52(L) thereof. The conduits are arranged such that gaseous coating material can only reach the substrate 48 by passing through the mask, and can only pass through the mask via the conduits. In a preferred method of using mask 64, planet 58 would be arranged with respect to a source or sources (not shown) of gaseous coating material, such that, in the absence of mask 64, a layer of about uniform thickness would be deposited on surface 50 of substrate 48. In such a case, positioning of mask 64 as shown would provide a layer 66, having a thickness graded in an inverse relationship to the length gradation of conduits 52 of mask 64 in the plane illustrated in FIG. 4.

The length/thickness relationship may vary according to the source type used to provide gaseous coating material, and to the geometrical arrangement of the rotary drive system. A relationship can be quickly determined either mathematically or by simple experiment.

Preferably, conduits 52 have a diameter (or maximum dimension for non-circular cross-sections) of between about 1.0 and 6.0 mm. Preferably, but not necessarily, the mask is arranged such that conduits 52 have corresponding ends thereof aligned in the same plane 68. Plane 68 is preferably arranged parallel to plane 50 of substrate 48 and at a distance between about 5.0 and 50.0 millimeters (mm) therefrom. If a mask is spaced from the substrate by a distance about equal to a conduit diameter (maximum cross-section dimension) or less, an "impression" of individual conduits may appear in a deposited layer. A preferred spacing is about five to ten times the conduit diameter (maximum cross-section dimension). In this spacing a sub-area on the substrate having an area equal to the cross-sectional area of a conduit receives gaseous coating material from several adjacent conduits. This smoothes the grading of layer thickness, rendering the conduit pattern undetectable.

A further measure to prevent detectability of the conduit pattern involves backfilling chamber 20 with a suitable gas during deposition of the coating materials. When depositing oxides, for example titanium dioxide or fused silica (which are commonly used in the production of dichroic filters and the like for the visible region of the electromagnetic spectrum), oxygen is preferably introduced into the chamber. When depositing materials other than oxides, for example magnesium fluoride, an inert gas such as argon may be used. When introducing oxygen or any other gas into the chamber, a pressure of about 5 x 10⁻⁴ millibar is preferably maintained therein. This allows the mask to be located closer to the substrate than would be possible without the introduction of such gasses.

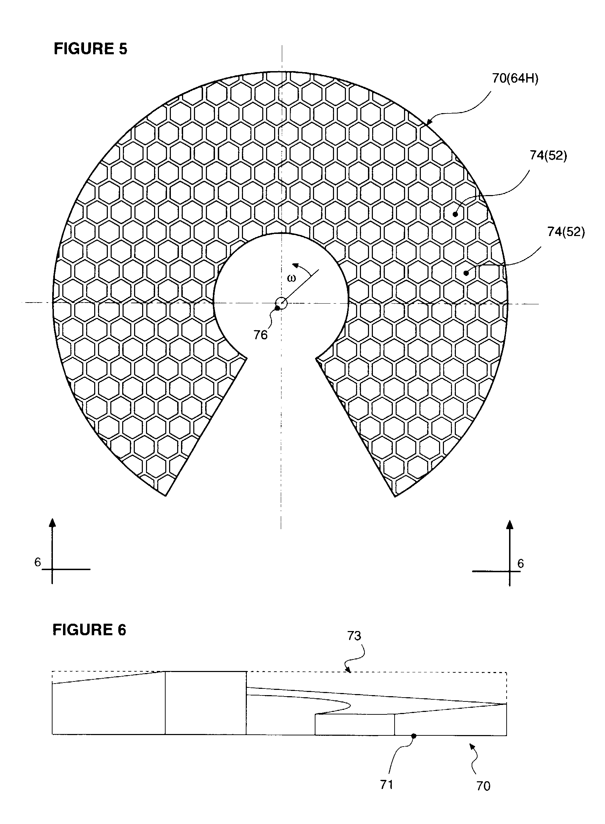

Referring now to FIGS 5, 6, 7, and 8, one convenient method of making a variable transmission mask in accordance with the present invention, suitable for depositing a circular variable filter by the method of the present invention is illustrated. The circular variable filter is required to have a characteristic wavelength, such as a passband wavelength in a bandpass filter, or a cut-on or cut-off wavelength in a dichroic filter, which varies with (azimuthal) angular position around the filter. The mask is formed from a parallel-sided block 70 of a "honeycomb" material having upper and lower sides 71 and 73 respectively. Hexagonal-shaped "cells" 74 of the material will form conduits 52 of the finished mask. One preferred honeycomb material, made from aluminum and having hexagonal cells of about 4.0 mm maximum cross-section dimension is a available from Hexcel Inc. of Pleasanton, California. This cell size is sufficiently large that a mask may be used a great many times before restriction of the cells by condensed coating material significantly affects performance of the mask.

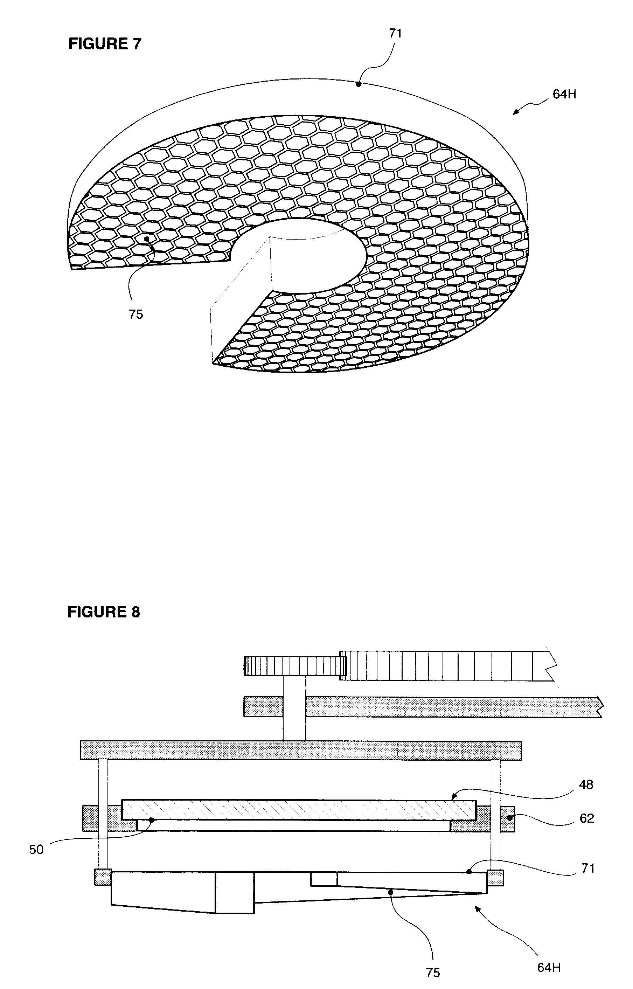

Block 70 is formed into an annular segment shape (see FIG. 5), having a central axis 76. Side 73 of block 70 is then cut or machined such that cells have length linearly varying with angular position ω. The machined surface of finished mask 64H thus has a form which may be defined as helicoid. This is illustrated in FIG. 7 as surface 75. For ease of illustration, depiction of hexagonal cells and conduit form is merely indicative of the general configuration and surface contour. In use, mask 64H is located with side 71 of original honeycomb block 70 facing surface 50 of substrate 48 and machined surface 75 of mask 64H furthest from substrate 48 as illustrated in FIG. 8.

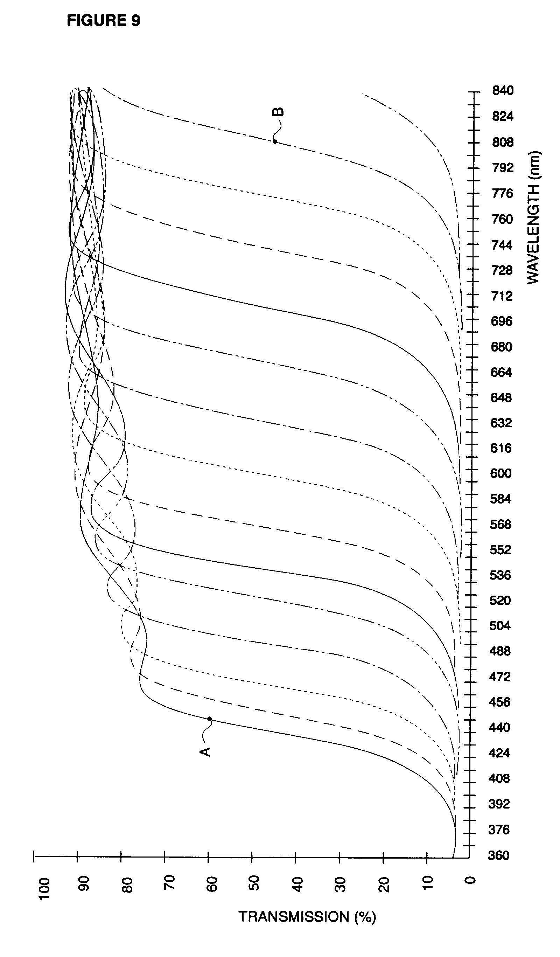

FIG. 9 depicts measured transmission as a function of wavelength at various azimuthal positions on a segment of a circular variable dichroic filter deposited through a mask of the form shown in FIG. 7. Curves A and B of FIG. 9 represent measurement positions separated by 260° of azimuth. Intermediate curves are measured at 20° intervals. The mask has a 188 mm overall diameter, a cell width of 4.76 mm, a cell wall thickness of 0.25 mm, a minimum cell length of 4 mm and a maximum cell length of 10.5 mm. Cell length varies approximately linearly with azimuthal position. The mask was located about 38 mm from the filter substrate during deposition. This distance may be reduced to 28 mm if gas is introduced into the chamber as discussed above. The filter had a functional annulus outer diameter of 140 mm, a functional annulus width of 32 mm, and a functional arc of about 300°.

Layers of the filter were alternating layers of magnesium fluoride and zinc sulphide. The magnesium fluoride was deposited from an electron-beam source. The zinc sulphide was evaporated from a resistance heated source. The substrate was held in a planetary fixture having a 290 mm orbit radius. Source to substrate height was about 700 mm. The electron-beam and resistance heated sources were offset respectively 210 mm and 245 mm from the planetary orbit axis.

It is pointed out here that the cut-on edge wavelength does not necessarily exhibit an exact inverse linear relationship to the corresponding conduit length. However, when a honeycomb mask is fabricated as discussed above by numerically controlled machining, or by spark erosion, the profile of the mask can be precorrected to compensate for any such divergence from linearity (or any other desired relationship).

Conduits of masks 64 in accordance with the present invention have been described as being equal in diameter or maximum cross-sectional dimension. This should not be construed as limiting. The acceptance angle of a conduit is defined by the ratio of height to diameter or maximum cross-sectional dimension. Thus, the local transmittance of the mask can equally be controlled by varying the diameter of the conduits, either alone or in conjunction with varying their length. Whether or not conduits have the same diameter, however, it is preferable, although not essential, that the cross-sectional form of the conduits be at least biaxially symmetrical, and most preferably as close to circular as possible, such that angular acceptance characteristics of a conduit are substantially the same whatever its orientation with respect to a source of gaseous coating material. The hexagonal form illustrated in FIG. 5 provides an adequate approximation to roundness while allowing for optimal packing of conduits and limiting obscuration due to the wall thickness of the conduits.

The foregoing description has been directed to masks designed for use with a flat substrate, for providing a layer or layers having a graded thickness. The method however is also applicable to providing a uniform layer on a steeply curved surface, or a uniform layer on a flat surface whereon, because of substrate size or apparatus size restrictions, a uniform layer could not be deposited solely by rotary motion, or combination of rotary motions, of the substrate.

In either case, it is simply necessary to determine, mathematically or practically, the gradation of layer thickness on the substrate which occurs with a particular rotary arrangement in the absence of a mask, and then construct a mask in accordance with the present invention, which, when used in combination with that rotary arrangement as described above, would modify that gradation such that a layer or layers of uniform thickness could be obtained.

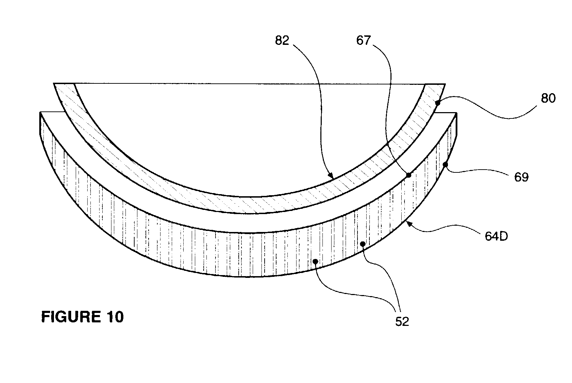

By way of example, FIG. 10 schematically illustrates one general form of a mask 64D in accordance with the present invention for providing a uniform layer or layers on a convex surface of a dome-shaped substrate 82. In most single or double rotation deposition arrangements, in the absence of a mask, a layer deposited on surface 80 would have a thickness near the center of the surface significantly greater than the thickness near the edge. Accordingly, mask 64D is arranged to shield the center of the surface from coating material more than the edge of the of the surface.

This is achieved by grading the length of conduits 52 extending through the mask, from a longest 52L at the center of the mask to a shortest 52S around the edge of the mask. The gradation of conduit length is selected such a uniform layer is deposited on surface 80. When coating convex surfaces, however, the greater the substrate curvature the greater is the largest angle of vapour incidence at the edge of the substrate. In vapour deposited layers, the greater the vapour incidence angle on a substrate (particularly when glancing angles are approached) the greater is the probability that the layer will have one or more defects such as excessive granularity, unacceptable porosity, poor abrasion resistance, or poor adhesion. The use of a mask 64D as depicted generically in FIG. 10 is doubly advantageous in that as well as assuring a uniform layer over the entire surface of the dome, the mask acts to limit the maximum angle of vapour incidence upon the substrate to an acceptable level, thus resulting in a defect free coating at all points on the surface. Preferably, conduits 52 are arranged such that ends thereof closest substrate 80 are equidistant from surface 80. Mask 64D may be formed from a block of honeycomb material as described above. In this case, however, both sides of the block would be machined to provide opposite curved sides 67 and 69 of the mask.

It will be appreciated from the foregoing description and corresponding illustrations that a graded transmission mask in accordance with the present invention may be described as "three-dimensional" inasmuch as it has a significant thickness compared with its area, and gradation of this thickness provides gradation of conduit length. The vertical surfaces of the conduits, which are in the third dimension, are responsible for the operation of this mask. Nevertheless, the mask may be quickly and inexpensively produced from commercially available honeycomb material by conventional computer controlled machining methods, or by spark erosion.

The method of the present invention may be used for any application in which layer thickness control is required, either for providing uniform layers, or layers with thickness spatially varied in a predetermined manner. Such applications include, however, are not limited to: correction or aspherizing optical surfaces; deposition of antireflection coatings or filter coatings (whether in the visible region or some other region of the electromagnetic spectrum) having spectral characteristics spatially varied over a surface in a predetermined manner, such as variable bandpass and edge filters, continuously variable beamsplitters, polarizers, Gaussian mirrors and variable attenuators; deposition of conductive layers or conductive-layer containing devices having resistivity varied in a predetermined manner; or deposition of uniform coatings on steeply curved surfaces. Unlike some other masking methods, no degree of symmetry is necessarily resultant in the grading effect.

The present invention has been described and depicted, in terms of a preferred and other embodiments. The invention is not limited, however, to those embodiments described and depicted. Rather the invention is limited only by the claims appended hereto.

## Claims

1. A method for vacuum deposition of a layer of material on a substrate,
comprising the steps of:
causing the material in a gaseous form
to impinge and condense upon the substrate;
while partially shielding the substrate from the gaseous material,
by locating a mask
between the substrate and a gaseous material source;
the mask extending at least partially over the substrate,
and including a plurality of conduits,
extending from one side thereof to the other,
through which the gaseous form of the material can pass selectively
to reach the substrate;
the nature and effect of the conduits being varied
over the mask area
in a predetermined manner,
for controlling depth of the layer of material
deposited on the substrate.

2. A deposition method as claimed in Claim 1,
wherein the mask is located in a fixed relative position to the substrate.

3. A deposition method as claimed in either of the preceding claims,
deploying diverse mask conduit lengths.

4. A deposition method as claimed in any of the preceding claims,
deploying diverse mask conduit cross-sectional dimensions.

5. A deposition method as claimed in any of the preceding claims, deploying a diversity of mask conduit lengths and/or cross-sections to provide a deposition layer of predetermined spatial thickness variation or constancy.

6. A deposition method as claimed in any of the preceding claims,
using a multi-cellular honeycomb mask,
with an array of cells
extending from one side of the mask to the other,
to provide said conduits.

7. A deposition method as claimed in any of the preceding claims, including conduits of polygonal cross section.

8. A deposition method as claimed in either of the preceding claims, including conduits of hexagonal cross section.

9. A deposition method as claimed in any of the preceding claims, including conduits in parallel alignment.

10. A deposition method as claimed in any of the preceding claims, wherein the ends of the conduits closer to the substrate are located about equidistant therefrom.

11. A deposition method as claimed in any of the preceding claims,
wherein the ends of the conduits closer to the substrate
are spaced apart from the substrate
by a distance about five to ten times
the conduit cross-sectional span.

12. A deposition method as claimed in any of the preceding claims, wherein the side of mask facing the substrate is flat.

13. A deposition method as claimed in any of the preceding claims,
wherein
the substrate and mask are rotated
with respect to the gaseous material source,
such that gaseous material from the source
is incident on any sub-area of the mask,
at a range of incidence angles,
depending on the location of the sub-area of the mask
and the rotary path of the sub-area
with respect to the gaseous material source;
each conduit having a characteristic 'angular acceptance' for the gaseous material,
the angular acceptance of the conduits
being inversely related to the ratio of length to diameter of the conduits,
the amount of gaseous material transmitted by the conduits
being directly related to the acceptance angle.

14. A method for vacuum deposition of a layer of material on a substrate, comprising the steps of
vaporising the deposition material,
at a source,
spaced from the substrate,
within a vacuum environment,
directing the vaporised material towards the substrate,
selectively deflecting or masking
a vapour path between the vapour source and the substrate,
by introducing deflector elements,
of spatially varying effect,
the degree and nature of the deflection or masking
corresponding to a desired deposition pattern.

15. A substrate
with a coating of predetermined, spatially varying or even depth over its surface, produced by the deposition method,
as claimed in any of the preceding claims.

16. An optical filter
with an optical coating of varying depth,
produced by the deposition method as described in any of the Claims 1 through 14

17. A circular optical filter disc,
as claimed in Claim 16, with an annular translucent optical coating,
of depth and optical transmission characteristic
varying progressively around the disc circumference.

18. Apparatus for deposition upon a substrate, comprising:
a vacuum chamber,
to receive a substrate to be coated,
vaporising means for vaporising a material to be deposited,
and directing the material in a gaseous form
to impinge and condense upon the substrate;
a mask between the substrate and the vaporising means,
partially shielding the substrate from the gaseous material;
the mask extending at least partially over the substrate,
and including a plurality of conduits,
extending from one side thereof to the other,
through which the gaseous material can pass
from the source to reach the substrate;
the respective lengths of the conduits differing
over the mask area
in a predetermined manner,
to achieve a desired deposition layer depth
and spatial distribution upon the substrate.

19. Apparatus for vacuum deposition of a layer of material on a substrate comprising:
a gaseous material source;
and a mask,
partially shielding the substrate,
and having a plurality of conduits,
allowing predetermined penetration of the mask
by the gaseous material.

20. A method for vacuum deposition of a layer of material on a substrate, using the apparatus of either Claims 18 or 19 and
comprising the steps of:
causing the material in a gaseous form
to impinge and condense upon the substrate;
while partially shielding the substrate from the gaseous material,
by the mask
between the substrate and a gaseous material source;
the mask extending at least partially over the substrate,
for controlling spatial variation of thickness
of the layer of material being deposited on the substrate.

21. A method as claimed in Claim 20,
wherein
the substrate and mask are rotated
with respect to the gaseous material source
such that gaseous material from the source
is incident on any sub-area of the mask
at a range of incidence angles
depending on the location of the sub-area of the mask
and the rotary path of the sub-area
with respect to the gaseous material source;
each conduit having a characteristic angular acceptance for the gaseous material, the angular acceptance of the conduits
being inversely related to the ratio of length to diameter of the conduits,
the amount of gaseous material transmitted by the conduits being directly related to the acceptance angle.

22. A mask,
for use in the masked vacuum deposition method
comprising a plurality of conduits,
juxtaposed alongside one another in an array
corresponding to a desired spatial variation in coating deposition depth.

23. A mask as claimed in Claim 22,
with a selective combination of conduit depths
and cross-sectional shapes and sizes
to achieve a desired coating depth distribution.

24. A mask as claimed in Claim 22 or 23,
of a multi-cellular material
with a cell array extending from one side of the mask to the other to provide conduits.

25. A mask as claimed in Claim 24,
wherein the conduits have a polygonal cross-section.

26. A mask as claimed in Claim 24,
wherein the conduits have a hexagonal cross-section.

27. A mask,
substantially as hereinbefore described
with reference to and as shown in the accompanying drawings.
